# EUROPÄISCHE PATENTSCHRIFT

(11) **EP 1 174 781 B1**
(45) Veröffentlichungstag und Bekanntmachung des Hinweises auf die Patenterteilung: **14.07.2010**
(21) Anmeldenummer: 01112418.7
(22) Anmeldetag: 21.05.2001
(51) Int. Cl.: G05B 19/05

(54) **Einrichtung zur Signalübertragung**
Signal transmission apparatus
Appareil de transmission de signal

(30) Priorität: 22.05.2000 DE 20009207 U
(43) Veröffentlichungstag der Anmeldung: 23.01.2002
(73) Patentinhaber: Pepperl + Fuchs GmbH, 68307 Mannheim (DE)
(72) Erfinder: Schwarz, Gerhard, 69636 Schoenbrunn-Allemuehl (DE); Becker, Udo, 45481 Muehlheim (DE); Hillebrand, Rainer, 44879 Bochum (DE)
(74) Vertreter: Schiffer, Axel Martin

(56) Entgegenhaltungen:
- EP-A- 0 713 360
- DE-A1- 4 225 573
- DE-A1- 19 512 372
- US-A- 5 508 886

## Beschreibung

Die Erfindung betrifft eine Einrichtung zur Signalübertragung zwischen einem Automatisierungssystem und Feldgeräten mit einer Trägerplatte und darauf aufsteckbaren Modulen, welche Anschlüsse für insbesondere die Feldgeräte aufweisen, wobei an der Trägerplatte Datenleitungen eines lokalen Busses und Spannungsversorgungsleitungen angeordnet sind, sowie die Module zumindest Lokalbusschnittstellen aufweisen, und mit wenigstens einem auf die Trägerplatte aufsteckbaren Buskoppelmodul, welches eine Lokalbusschnittstelle und eine Feldbusschnittstelle zur Kommunikation mit den Modulen bzw. dem Automatisierungssystem aufweist.

Eine solche Einrichtung ist aus der WO 96/31815 bekannt. Die vorbekannte Einrichtung dient zur eigensicheren Signalanpassung, um eine im Sinne des Explosionsschutzes sichere Trennung des Signalflusses zwischen einem Automatisierungssystem und sogenannten Feldgeräten, also Sensoren und Aktoren, in einem explosionsgefährdeten Prozess zu ermöglichen.

Das Anschließen der Feldgeräte erfolgt über Module, die auf eine Trägerplatte aufsteckbar sind. An der Trägerplatte sind in der Regel zumindest Datenleitungen in Form eines Lokalbusses sowie Spannungsversorgungsleitungen angeordnet, mit denen die Module über entsprechende Schnittstellen im aufgesteckten Zustand in Verbindung sind. Um die Verbindung zum Automatisierungssystem herzustellen, ist ein Buskoppelmodul ebenfalls auf die Trägerplatte aufgesteckt. Dieses weist sowohl eine Lokalbusschnittstelle als auch eine Feldbusschnittstelle auf. Über die Lokalbusschnittstelle erfolgt die Kommunikation mit den Modulen und über die Feldbusschnittstelle erfolgt die Kommunikation mit dem Automatisierungssystem.

Bei der vorbekannten Einrichtung weisen alle Module die gleiche Breite auf, in der Regel 16 mm, um in genormte Steckplätze der Trägerplatte an beliebiger Stelle einsteckbar zu sein. Die Module stellen in Abhängigkeit von der Art der Module entweder je einen, zwei oder höchstens drei Kanäle zur Verfügung. An die Module sind entsprechende Feldgeräte, wie Sensoren, Aktoren oder dergleichen anschließbar.

Eine weitere gattungsgemäße Einrichtung zur Signalübertragung und -anpassung zwischen einem Automatisierungssystem und Feldgeräten ist aus DE 195 12 372 A1 bekannt. Die Einrichtung umfasst eine Rückwandplatine, auf welcher darauf aufsteckbare Module zur Kommunikation mit Feldgeräten vorhanden sind, und auf welcher ein Kommunikationsmodul zur Verbindung mit dem Automatisierungssystem vorhanden ist. Hierbei haben jedoch alle Module die gleiche Breite.

Eine weitere Vorrichtung zur Signalübertragung zwischen einer Steuervorrichtung und Feldgeräten wird in EP 0 713 360 A2 beschrieben. Hierzu ist eine Rückwandplatine mit Aufnahmevorrichtungen vorgesehen, an welche verschiedene elektrische Bauteile angeschlossen werden.

Der Erfindung liegt die Aufgabe zugrunde, die Einrichtung zur Signalübertragung der eingangs genannten Art dahingehend zu verbessern, dass mehr Variationsmöglichkeiten bei der Modulanordnung an der Trägerplatte bei gleichzeitig reduzierten Kosten pro Kanal möglich sind.

Diese Aufgabe wird im Zusammenhang mit den Merkmalen des Oberbegriffs des Patentanspruchs 1 dadurch gelöst, dass Module mit einfacher und zumindest doppelter Steckplatzbreite auf entsprechende Steckplätze der Trägerplatte aufsteckbar und von dem Buskoppelmodul und/oder dem Automatisierungssystem identifizierbar sind.

Durch die Verwendung von Modulen unterschiedlicher Steckplatzbreiten ist es möglich, die Einrichtung zur Signalübertragung variabel aufzubauen und je nach Erfordernis Module unterschiedlicher Steckplatzbreiten zu verwenden. Dabei besteht nicht die Notwendigkeit, hardware- oder softwaremäßig die Anordnung der verschiedenen Module extern einzugeben. Statt dessen erfolgt eine Identifizierung der Module und der Anordnung der Module über den Lokalbus mittels des Buskoppelmoduls oder auch direkt über das Automatisierungssystem.

Bei der erfindungsgemäßen Einrichtung ist es möglich, nur jeweils Module mit einfacher oder doppelter Steckplatzbreite zu verwenden und entsprechend zu identifizieren oder beide Arten von Modulen auf einer Trägerplatte aufzustecken und entsprechend zu identifizieren.

An der Trägerplatte findet keine Modifikation hinsichtlich beispielsweise der Module mit doppelter Steckplatzbreite statt, da diese auf die vorhandenen Steckplätze aufsteckbar sind. Dadurch können auch bereits an einer Wand oder an einem Schaltschrank installierte Trägerplatten zum Ausbau mit Modulen doppelter Steckplatzbreite aufgerüstet werden. Dies kann durch Verwendung eines hardwaremäßig angepassten Buskoppelmoduls oder entsprechende Programmierung des vorhandenen Buskoppelmoduls vom Automatisierungssystem erfolgen.

Die Trägerplatte ist in üblicher Weise als sogenannte Backplane ausgebildet, siehe auch den obengenannten Stand der Technik.

Um im Zusammenhang mit den Modulen größerer Steckplatzbreite gleichzeitig mehr Kanäle zur Verfügung zu stellen, können zumindest die Module mit der doppelten Steckplatzbreite Vielkanal-Module sein. Diese können beispielsweise 8 Kanäle pro Modul bereitstellen. Dadurch wird die Anzahl der Kanäle pro Modul und damit auch pro Trägerplattform erheblich erhöht, wodurch die Kosten pro Kanal weiter reduzierbar sind.

Die Module mit einfacher Steckplatzbreite können insbesondere dann verwendet werden, wenn Kanäle mit erhöhter Priorität bereitgestellt werden müssen.
Da die Module mit einfacher und größerer Steckplatzbreite bezüglich der Steckplätze genormt sind und eine Identifizierung unabhängig von der Position der entsprechenden Module auf der Trägerplatte erfolgen kann, können Module unterschiedlicher Steckplatzbreiten beliebig kombiniert werden.

Die Identifizierung eines Moduls kann beispielsweise dadurch erfolgen, dass die verschiedenen Steckplätze bezüglich ihrer Belegung und anschließend über die Steckplätze das entsprechend aufgesteckte Modul abgefragt wird. Dabei kann festgestellt werden, ob beispielsweise zwei nebeneinander liegende Steckplätze von nur einem Modul besetzt sind, was daraufhin als Modul mit doppelter Steckplatzbreite identifizierbar ist.

Um die Identifizierung der verschiedenen Module zu vereinfachen, weisen die Module Kodiereinrichtungen auf.

Damit die Kodierung der entsprechenden Module auch nach Aufstecken auf die Trägerplatte in einfacher Weise erfolgen kann, sind die Kodiereinrichtungen vom Buskoppelmodul und/oder von dem Automatisierungssystem programmierbar oder einstellbar. Auf diese Weise kann jedem Modul extern über den lokalen Bus eine Adresse oder Identifizierung zugeordnet werden, die im Modul entsprechend abgespeichert wird und jederzeit wieder abrufbar ist.

Ebenso besteht die Möglichkeit, die Module bereits vor Aufstecken mittels Software bezüglich einer Identifizierkodierung zu programmieren und/oder einzustellen, wobei dies über einen Computer, das Automatisierungssystem oder dergleichen erfolgen kann. Ebenso ist es möglich, die Kodierung der Module durch entsprechende Betätigungseinrichtungen (Hardware) von außen und manuell durchzuführen.

Um direkt vom Buskoppelmodul eine Initialisierung oder Steuerung der verschiedenen Module auf der zugehörigen Trägerplatte durchführen zu können, kann das Buskoppelmodul eine Konfiguration- und/oder Parameterspeichereinrichtung aufweisen. Diesen können entsprechende Daten über eine entsprechende Interfaceeinrichtung oder auch vom Automatisierungssystem direkt eingegeben werden. An dieser Stelle sei angemerkt, dass ein solches Automatisierungssystem beispielsweise eine speicherprogrammierbare Steuerung oder ein Leitsystem sein kann.

Im Zusammenhang mit der Speichereinrichtung in dem Buskoppelmodul ist es weiterhin als vorteilhaft zu betrachten, wenn die Speichereinrichtung nicht flüchtig ist, damit bei Ausfall der Spannungsversorgung die entsprechenden Konfigurations- und Parameterdaten nicht verloren gehen.

Um auch die Spannungsversorgung für die entsprechende Trägerplatte in einfacher Weise anordnen zu können, kann wenigstens ein Netzteilmodul auf der Trägerplatte aufsteckbar sein. Es sind natürlich auch mehr Netzteilmodule pro Trägerplatte möglich, wenn beispielsweise ein Ersatznetzteilmodul oder dergleichen vorgesehen ist. Dies gilt analog für das Buskoppelmodul, für das aus Gründen der Redundanz oder zur Bereitstellung beispielsweise zweier Busanschlüsse zum Automatisierungssystem ein weiteres Buskoppelmodul zugeordnet sein kann.

Um die Trägerplatte je nach Anforderung aufbauen zu können, kann diese aus Trägerplattenmodulen aufgebaut sein. Diese sind miteinander lösbar verbindbar, wobei in diesem Zusammenhang auch gleichzeitig die entsprechenden Verbindungen des lokalen Busses und der Spannungsversorgungsleitungen hergestellt werden.

Um zum externen Zugang eine zusätzliche Spannungsversorgung bzw. entsprechende Schnittstellen für die Einrichtung zur Signalübertragung bereitzustellen, kann wenigstens ein Trägerplattenmodul als Interfacemodul und/oder Hilfsenergieanschlussmodul ausgebildet sein. Das Interfacemodul weist die entsprechenden Schnittstellen für üblicherweise verwendete Bussysteme oder dergleichen auf. Vorzugsweise werden Interfacemodul und/oder Hilfsenergieanschlussmodul an den Enden der Trägerplatte angebracht.

Um einen Status eines Moduls oder auch andere Parameter des Moduls optisch darzustellen, kann das Modul wenigstens eine Anzeigeeinrichtung aufweisen. Eine solche Anzeigeeinrichtung kann beispielsweise eine oder mehrere LED in unterschiedlichen Farben aufweisen.

Um die Signale zwischen Feldgeräten und Automatisierungssystem in entsprechender Weise umzusetzen, kann das Modul ein I/O-Signalanpassungsmodul sein.

Um in explosionsgefährdeten Bereichen die erfindungsgemäße Einrichtung zur Signalanpassung anwenden zu können, können zumindest die Module mit einfacher Steckplatzbreite als explosionsgeschützte und/oder eigensichere elektrische Betriebsmittel ausgebildet sein.

Zur einfachen Verbindung des Feldgerätes mit dem Modul, kann dieses eine frontseitige Schraub-Steckverbindungseinrichtung aufweisen. Weiterhin kann eine solche Verbindungseinrichtung auch als Stecker mit Federkraftanschluss, als Stecker mit Haube oder dergleichen aufgebaut sein.

Im Folgenden wird ein vorteilhaftes Ausführungsbeispiel der Erfindung anhand der in der Zeichnung beigefügten Figuren näher erläutert.

Es zeigen:
- Fig. 1: Eine perspektivische Vorderansicht einer erfindungsgemäßen Einrichtung zur Signalanpassung mit auf einer Trägerplatte aufgesteckten Modulen, und
- Fig. 2: eine Vorderansicht einer Trägerplatte nach Fig. 1 mit teilweise entfernten Modulen.

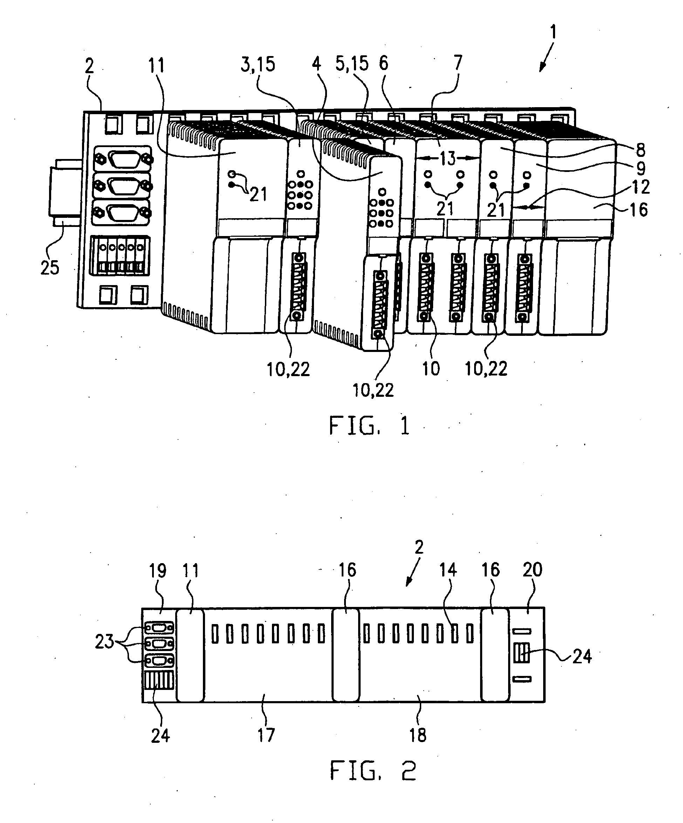

In Fig. 1 ist ein Ausführungsbeispiel einer erfindungsgemäßen Einrichtung 1 zur Signalanpassung in perspektivischer Vorderansicht dargestellt. Die Einrichtung weist eine Trägerplatte 2, d.h. eine sogenannte Backplane auf. Diese ist an einer Tragschiene 25 lösbar befestigt, die beispielsweise zur Wandmontage oder zur Montage in einem nicht dargestellten Schaltschrank dient. Die Tragschiene 25 ist genormt.

Auf der Trägerplatte 2 befinden sich eine Vielzahl von Steckplätzen 14, siehe Fig. 2, auf die Module 3-9 als I/O-Signalanpassungsmodul aufsteckbar sind. Weiterhin sind ein Buskoppelmodul 11 und ein Netzteilmodul 16 auf die Trägerplatte 2 aufgesteckt. Die Signalanpassungsmodule 3-9 besetzen je nach ihrer Breite einen oder mehrere Steckplätze 14. Beispielsweise benötigen die Module 3, 4, 5, 6, 8 und 9 jeweils einen Steckplatz und sind entsprechend mit einfacher Steckplatzbreite 12 ausgebildet, während das Modul 7 zwei Steckplätze 14 besetzt und mit doppelter Steckplatzbreite 13 ausgebildet ist.

Module unterschiedlicher Steckplatzbreiten sind beliebig miteinander kombinierbar.

Jedes Signalanpassungsmodul 3-9 weist eine Kodiereinrichtung 15 auf, die software- oder hardwaremäßig realisiert ist und vom Buskoppelmodul 11 abfragbar ist. Die Abfrage erfolgt über einen an der Trägerplatte 2 angeordneten lokalen Bus, auf den alle Module über die entsprechenden Steckplätze 14 Zugriff haben. Weiterhin erfolgt die Spannungsversorgung der verschiedenen Module ebenfalls über die Steckplätze 14, die mit an der Trägerplatte 2 angeordneten Spannungsversorgungsleitungen verbunden sind. Die Einspeisung der entsprechenden Spannung erfolgt über das Netzteilmodul 16.

An ihren Vorderseiten weisen die Signalanpassungsmodule 3-9 Anschlüsse 10 in Form von Schraub-Steckverbindungseinrichtungen 22 auf. Auf diese sind entsprechende, mit nicht dargestellten Feldgeräten verbundene Schraub-Steckverbinder aufsteckbar. Dabei besteht die Möglichkeit, die Verbinder und entsprechend die Verbindungseinrichtungen mechanisch zu kodieren, um falsch eingebaute Verbinder oder Verwechslungen auszuschließen.

Das Signalanpassungsmodul 7 mit doppelter Steckplatzbreite 13 ist als Vielkanal-Modul ausgebildet. Beispielsweise kann es achtkanalig aufgebaut sein, um entsprechend acht verschiedenen Feldgeräten oder anderen Einrichtungen zugeordnet zu sein. Die übrigen Signalanpassungsmodule 3, 4, 5, 6, 8, 9 sind in der Regel nur einkanalig oder zweikanalig ausgebildet und dienen zur Bereitstellung von Kanälen mit höherer Priorität und insbesondere zur Bereitstellung explosionsgeschützter und eigensicherer Anschlüsse.

Die verschiedenen Module weisen an ihrer Frontseite Anzeigeeinrichtungen 21 auf. Diese sind beispielsweise durch LEDs unterschiedlicher Farben gebildet.

Die Trägerplatte 2 ist ebenfalls modulartig aus einer Reihe von Trägerplattenmodulen 17, 18, siehe Fig. 2 und an ihren Enden durch Interfacemodul 19 und Hilfsenergieanschlussmodul 20 zusammengesetzt. Zur Verbindung zwischen den verschiedenen Modulen ist beispielsweise das Buskoppelmodul 11 bzw. das Netzteilmodul 16 einsetzbar, siehe wiederum Fig. 2.

Das Interfacemodul 19 weist eine Reihe von Anschlüssen 23 auf, an die verschiedene Bussysteme anschließbar sind. Weiterhin kann es Hilfsenergieanschlüsse 24 aufweisen, die ebenfalls am Hilfsenergieanschlussmodul 20 vorgesehen sind.

Erfindungsgemäß ist es möglich, eine Einrichtung zur Signalanpassung mit Modulen unterschiedlicher Steckplatzbreiten in beliebiger Anordnung auf der Trägerplatte einzusetzen, bei der die verschiedenen Module identifizierbar und den entsprechenden Steckplätzen auf der Trägerplatte zuordbar sind. Die Module können analog oder digital arbeiten und die Module mit größerer Breite weisen zumindest acht Kanäle auf. Dadurch sind eine erhöhte Anzahl von Kanälen pro Trägerplatte und reduzierte Kosten pro Kanal möglich. Bezüglich der Anordnung der verschiedenen Module auf der Trägerplatte gibt es keine Einschränkungen, wobei die Module beliebig miteinander auf der Trägerplatte kombinierbar sind. Die Module dienen als I/O-Signalanpassungsmodul für beispielsweise Ventile, Initiatoren, Optokoppler, Messumformer, Thermoelemente oder dergleichen. Die Befestigung an der Trägerplatte erfolgt durch Schnappmontage an den entsprechenden Steckplätzen.

Die Programmierung der erfindungsgemäßen Einrichtung erfolgt vorteilhafterweise vom Automatisierungssystem her über eine entsprechende Busverbindung mit dem Buskoppelmodul oder auch über die Busanschlüsse 23 am Interfacemodul, d.h. von außen und unabhängig vom Automatisierungssystem.

## Patentansprüche

1. Einrichtung (1) zur Signalübertragung zwischen einem Automatisierungssystem und Feldgeräten mit einer Trägerplatte (2) und darauf aufsteckbaren Modulen (3-9,11, 16), welche Anschlüsse (10) für insbesondere Feldgeräte aufweisen, wobei an der Trägerplatte (2) Datenleitungen eines lokalen Busses und Spannungsversorgungsleitungen angeordnet sind, sowie die Module (3-9,11,16) zumindest Lokalbusschnittstellen aufweisen, und mit wenigstens einem auf die Trägerplatte (2) aufsteckbaren Buskoppelmodul (11), welches eine Lokalbusschnittstelle und eine Feldbusschnittstelle zur Kommunikation mit den Modulen (3 - 9, 16) bzw. dem Automatisierungssystem aufweist, und
wobei die Module (3 - 9) von dem Buskoppelmodul (11) und/oder dem Automatisierungssystem identifizierbar sind,
**dadurch gekennzeichnet,**
**dass** Module (3 - 9) je nach ihrer Breite einen oder mehrere Steckplätze (14) der Trägerplatte (2) besetzen,
**dass** das Modul (3 - 9) eine Kodiereinrichtung (15) zur Identifizierung aufweist, dass die Kodiereinrichtung (15) vom Buskoppelmodul (11) und/oder von dem Automatisierungssystem programmierbar ist und
**dass** die Kodiereinrichtung (15) vor Aufstecken des Moduls (3 - 9) programmierbar und/oder einstellbar ist.

2. Einrichtung zur Signalübertragung nach Anspruch 1,
**dadurch gekennzeichnet,**
**dass** zumindest die Module (7) mit doppelter Steckplatzbreite (13) Vielkanal-Module sind.

3. Einrichtung zur Signalübertragung nach Anspruch 1 oder 2,
**dadurch gekennzeichnet,**
**dass** die Module (3 - 9) unterschiedlicher Steckplatzbreiten (12, 13) beliebig kombinierbar sind.

4. Einrichtung zur Signalübertragung nach wenigstens einem der vorangehenden Ansprüche,
**dadurch gekennzeichnet,**
**dass** das Buskoppelmodul (11) eine Konfiguration- und/oder Parameterspeichereinrichtung aufweist.

5. Einrichtung zur Signalübertragung nach wenigstens einem der vorangehenden Ansprüche,
**dadurch gekennzeichnet,**
**dass** wenigstens ein Netzteilmodul (16) auf die Trägerplatte (2) aufsteckbar ist.

6. Einrichtung zur Signalübertragung nach wenigstens einem der vorangehenden Ansprüche,
**dadurch gekennzeichnet,**
**dass** die Trägerplatte (2) aus Trägerplattenmodulen (17, 18) aufgebaut ist.

7. Einrichtung zur Signalübertragung nach wenigstens einem der vorangehenden Ansprüche,
**dadurch gekennzeichnet,**
**dass** wenigstens ein Trägerplattenmodul (17, 18) als Interfacemodul (19) und/oder Hilfsenergieanschlussmodul (20) ausgebildet ist.

8. Einrichtung zur Signalübertragung nach wenigstens einem der vorangehenden Ansprüche,
**dadurch gekennzeichnet,**
**dass** das Modul (3, 9, 11, 16) wenigstens eine Anzeigeeinrichtung (21) aufweist.

9. Einrichtung zur Signalübertragung nach wenigstens einem der vorangehenden Ansprüche,
**dadurch gekennzeichnet,**
**dass** das Modul (3 - 9) ein I/O-Signalanpassungsmodul ist.

10. Einrichtung zur Signalübertragung nach wenigstens einem der vorangehenden Ansprüche,
**dadurch gekennzeichnet,**
**dass** zumindest das Modul (3, 6, 8, 9) einfacher Steckplatzbreite (12) als explosionsgeschütztes und/oder eigensicheres elektrisches Betriebsmittel ausgebildet ist.

11. Einrichtung zur Signalübertragung nach wenigstens einem der vorangehenden Ansprüche,
**dadurch gekennzeichnet,**
**dass** das Modul (3 - 9) eine frontseitige Schraub-Steckverbindungseinrichtung aufweist.

## Claims

1. Device (1) for transmitting signals between an automation system and field devices, comprising a supporting plate (2) and modules (3-9, 11, 16) which are attachable to said supporting plate (2) and which are provided with terminals (10) especially for field devices, the supporting plate (2) having arranged thereon data lines of a local bus and voltage-supply lines, and said modules (3-9, 11, 16) having at least local bus interfaces, and comprising at least one bus coupling module (11) which is attachable to the supporting plate (2) and which is provided with a local bus interface and a field bus interface for communication with said modules (3-9, 16) and said automation system, respectively, and
the modules (3-9) being identifiable by the bus coupling module (11) and/or the automation system,
**characterized in that**
the modules (3-9) occupy a single or several plug-in places (14) according to their width,
the module (3-9) comprises an encoder (15) for the purpose of identification,
the encoder (15) is adapted to be programmed by the bus coupling module (11) and/or by the automation system, and
the encoder (15) is adapted to be programmed and/or adjusted prior to attaching the module (3-9).

2. Signal-transmission device according to claim 1,
**characterized in that**
at least the modules (7) having a double plug-in place width (13) are multichannel modules.

3. Signal-transmission device according to claim 1 or 2,
**characterized in that**
the modules (3-9) having different plug-in place widths (12, 13) can be combined in an arbitrary manner.

4. Signal-transmission device according to at least one of the preceding claims,
**characterized in that**
the bus coupling module (11) is provided with a configuration and/or parameter storage means.

5. Signal-transmission device according to at least one of the preceding claims,
**characterized in that**
at least one power supply unit module (16) is attachable to the supporting plate (2).

6. Signal-transmission device according to at least one of the preceding claims,
**characterized in that**
the supporting plate (2) is composed of supporting plate modules (17, 18).

7. Signal-transmission device according to at least one of the preceding claims,
**characterized in that**
at least one supporting plate module (17, 18) is implemented as an interface module (19) and/or as an auxiliary power supply module (20).

8. Signal-transmission device according to at least one of the preceding claims,
**characterized in that**
the module (3,9,11,16) is provided with at least one display means (21).

9. Signal-transmission device according to at least one of the preceding claims,
**characterized in that**
the module (3-9) is an I/O signal matching module.

10. Signal-transmission device according to at least one of the preceding claims,
**characterized in that**
at least the module (3, 6, 8, 9) having a single plug-in place width (12) is implemented as an explosion-proof and/or intrinsically safe electrical equipment.

11. Signal-transmission device according to at least one of the preceding claims,
**characterized in that**
the module (3-9) is provided with a screwed plug connection means on its front surface.

## Revendications

1. Dispositif (1) de transmission de signaux entre un système d'automatisation et des appareils de terrain, avec une plaque de support (2) et des modules (3 - 9, 11, 16) enfichables sur celle-ci, qui comportent des prises (10) pour, en particulier, des appareils de terrain, dans lequel des lignes de données d'un bus local et des lignes d'alimentation en tension sont placées sur la plaque de support (2), et les modules (3 - 9, 11, 16) comportent au moins des interfaces de bus local, et avec au moins un module (11) de couplage de bus enfichable sur la plaque de support (2), qui comprend une interface de bus local et une interface de bus de terrain pour communiquer avec les modules (3 - 9, 11, 16) ou avec le système d'automatisation, et
dans lequel les modules (3 - 9) sont identifiables par le module (11) de couplage de bus et/ou le système d'automatisation,
***caractérisé***
***en ce que*** des modules (3 - 9) occupent en fonction de leur largeur un ou plusieurs emplacements d'enfichage (14) de la plaque de support (2),
***en ce que*** le module (3 - 9) comprend un dispositif de codage (15) pour l'identification,
***en ce que*** le dispositif de codage (15) est programmable par le module (11) de couplage de bus et/ou par le système d'automatisation, et
***en ce que*** le dispositif de codage (15) peut être programmé et/ou réglé avant l'enfichage du module (3 - 9).

2. Dispositif de transmission de signaux selon la revendication 1, ***caractérisé en* ce *qu*'**au moins les modules (7) de double largeur d'enfichage (13) sont des modules multicanaux.

3. Dispositif de transmission de signaux selon la revendication 1 ou 2, ***caractérisé en ce que*** les modules (3 - 9) de différentes largeurs d'enfichage (12, 13) peuvent être combinés à volonté.

4. Dispositif de transmission de signaux selon au moins l'une des revendications précédentes, ***caractérisé en ce que*** le module (11) de couplage de bus comprend un dispositif de configuration et/ou de stockage de paramètres.

5. Dispositif de transmission de signaux selon au moins l'une des revendications précédentes, ***caractérisé en ce qu*'**au moins un module secteur (16) peut être enfiché sur la plaque de support (2).

6. Dispositif de transmission de signaux selon au moins l'une des revendications précédentes, ***caractérisé en ce que*** la plaque de support (2) est constitué de modules (17, 18) de plaque de support.

7. Dispositif de transmission de signaux selon au moins l'une des revendications précédentes, ***caractérisé en ce qu*'**au moins un module (17, 18) de plaque de support est conformé en module d'interface (19) et/ou module (20) de raccordement d'énergie auxiliaire.

8. Dispositif de transmission de signaux selon au moins l'une des revendications précédentes, ***caractérisé en ce que*** le module (3, 9, 11, 16) comprend au moins un dispositif d'affichage (21).

9. Dispositif de transmission de signaux selon au moins l'une des revendications précédentes, ***caractérisé en* ce *que*** le module (3 - 9) est un module d'adaptation de signal d'E/S.

10. Dispositif de transmission de signaux selon au moins l'une des revendications précédentes, ***caractérisé en ce qu*'**au moins le module (3, 6, 8, 9) de largeur d'enfichage (12) simple est conformé en moyen d'exploitation électrique protégé contre les risques d'explosion et/ou à sécurité intégrée.

11. Dispositif de transmission de signaux selon au moins l'une des revendications précédentes, ***caractérisé en ce que*** le module (3 - 9) présente un dispositif d'enfichage-vissage frontal.
